# EUROPEAN PATENT SPECIFICATION

(11) **EP 1 160 969 B1**
(45) Date of publication and mention of the grant of the patent: **16.08.2006**
(21) Application number: 00111503.9
(22) Date of filing: 29.05.2000
(51) Int. Cl.: H03D 1/04

(54) **Detection of distorsions in AM signals**
Detektion von Verzerrungen bei AM Signalen
Détection de distorsion de signaux AM

(43) Date of publication of application: 05.12.2001
(73) Proprietor: Sony Deutschland GmbH, 50829 Köln (DE)
(72) Inventor: Nöthlings, Rolf, c/o Advanced Technology Center, 70327 Stuttgart (DE); Wildhagen, Jens, c/o Advanced Technology Center, 70327 Stuttgart (DE)
(74) Representative: Müller - Hoffmann & Partner

(56) References cited:
- DE-A- 19 734 040
- US-A- 5 168 214
- US-A- 5 353 260
- US-A- 6 060 878

## Description

The present invention relates to the detection of distortions in an AM signal, in particular to the detection of interferers, i. e. single sinus tones, caused by other technical devices or by distortion carriers from other transmitters, or other narrow band distortions.

Generally, in AM broadcasting signals are often disturbed by interferers which can be caused by other technical devices located more or less close to the receiver, e. g. a monitor which might behave as a transmitter in certain frequency ranges located close to the receiver can lead to heavy distortions.

Furthermore, document US 5 353 260 A discloses a method to detect distortions in an AM signal comprising the step of analyzing the energies of subbands of the AM signal.

It is the object underlying the present invention to provide an uncomplicated and reliable method and device to detect such distortions to be able to suppress them and a suitable device to detect such distortions.

This object is solved by the method defined in independent claim 1. Preferred embodiments thereof are respectively defined in the following claims 2 to 8. A device to detect such distortions is defined in independent claims 9 and 10. Preferred embodiments thereof are defined in the following dependent claims 11 and 12.

According to the present invention subbands of at least one sideband of the double sideband AM signal are analyzed to detect above-described distortions. Therefore, the present invention provides a reliable detection method, since not the whole AM signal or respective sideband thereof is processed in order to detect such distortions, but only subbands thereof.

Therefore, since the quadrature component is necessary for the generation of upper and lower sideband which mathematically equals to the difference of both sideband signals, preferrably this quadrature component is used for the analysis. Further, a higher order power of this quadrature component could also be used, but also therefore the generation of the quadrature component is necessary.

Depending on the wanted accuracy each of the analyzed subbands can cover a more or less wide frequency range. It is also possible that the subbands do not all cover the same frequency range, but a respective frequency range for a respective subband is determined according to a psychoacoustical rule in that frequency ranges with a higher sensitivity to the human ear are divided into more subbands than frequency ranges with less sensitivity to the human ear.

According to the present invention two alternatives are proposed to analyze the energies of subbands of the upper and/or lower sideband signal to determine whether a respective subband of the respective sideband signal is disturbed or not.

According to the first proposed preferred alternative corresponding to the subject-matter of independent claims 1 and 9, the energies of respective subbands of both sideband signals and of a respective difference signal thereof are determined and in case the respective difference signal has a level above a predetermined threshold the respective subband signal with the higher energy of the respective subband signals of both sidebands is determined as disturbed subband signal. The threshold might e. g. be related to the average energy of all subbands in that it is proportional thereto.

Of course, the predetermined threshold can have different values according to psychoacoustical observations so that only distortions are detected which can be heard by the human ear, 1. e. which are annoying to a human listener.

Alternatively, all frequencies having a level of the quadrature component of the coherent complex amplitude modulated signal which are lying above a predetermined threshold are determined to be disturbed frequencies and the respective corresponding subband of both sideband signals at one of those disturbed frequencies having the higher energy is determined to be the disturbed subband.

This second preferred alternative, corresponding to the subject-matter of independent Claim 10, has the advantage that only one signal has to be fully divided into subbands and the subbands of the single sideband signals have only to be generated for disturbed subbands.

Of course, as in the first embodiment according to the present invention, also in this case the predetermined threshold for every subband can be determined according to psychoacoustical observations.,

According to the present invention the subband analysis is preferably performed using a filterbank, a bandpass filter with variable center frequency which can be tuned over the whole frequency range, complex frequency shifts and lowpass filters, and/or a fast fourier transformation.

Further preferably, at least groups of subbands are processed in parallel.

Still further preferably, all energy values of subbands obtained during the respective subband analysis are lowpass filtered to avoid fast switching effects in the further interferer filters.

The present invention and its embodiments will be better understood from a detailed description of an exemplary embodiment thereof described in conjunction with the accompanying drawings, wherein
- **Fig. 1**: shows an undisturbed double sideband AM signal;
- **Fig. 2**: shows a double sideband AM signal which is disturbed by two interferers;
- **Fig. 3**: shows the analysis of the energies of a double sideband AM signal for one subband according to the present invention;
- **Fig. 4**: shows a block diagram of the subband analysis according to the present invention;
- **Fig. 5**: shows a more detailed block diagram of the subband analysis according to the present invention; and
- **Figs. 6 to 8**: shows signals in different signal processing stages of the subband analysis as shown in Fig. 5.

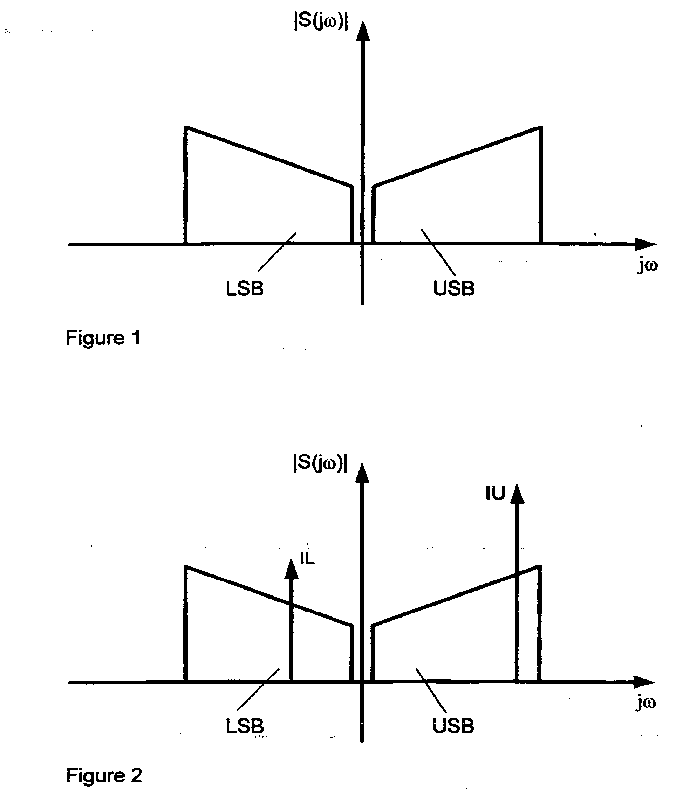

Fig. 1 shows an undisturbed double sideband AM signal which consists of two sidebands containing the same information, namely the lower sideband LSB and the upper sideband USB. The absolute value of the spectrum S(jω)| of the lower sideband LSB and the upper sideband USB is symmetrical, i. e. the value of the spectrum of a negative frequency -jω of the lower sideband LSB which covers the negative frequencies is equal to the value of the spectrum of the same positive frequency +jω of the upper sideband USB which covers the positive frequencies.

Interferers which result from single sinus tones caused by other technical devices or by distortion carriers from other transmitters usually appear in only one sideband. Fig. 2 shows a complex baseband signal with one interferer IL in the lower sideband LSB and one interferer IU in the upper sideband USB. Both interferers appear as a peak in the spectrum of the complex baseband signal, since they represent a single sinus tone, respectively. The grade of interference is dependent on the amplitude of the respective peak, i. e. on the absolute value of the spectrum | S(jω) | at the respective frequency jω of the interferer. In the shown example the interferer IL within the lower sideband LSB has a smaller amplitude than the interferer IU in the upper sideband USB.

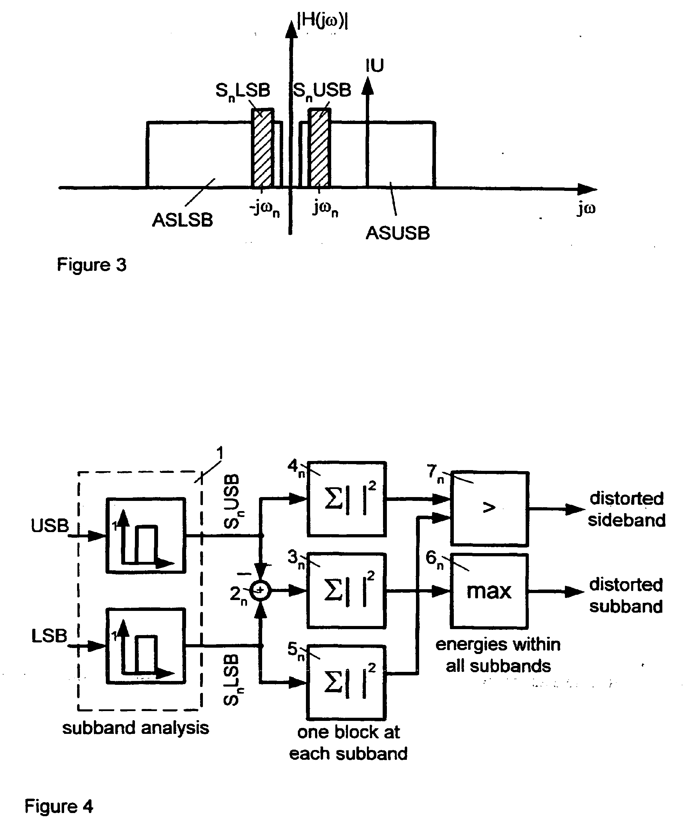

The present invention takes advantage of the fact that the two sidebands in AM broadcasting contain the same information, i. e. a redundancy is given. Therefore, it is possible to compare the relating parts of the two sidebands of the coherent signal to detect distortions. As shown in Fig. 3, the two single sideband signals are filtered into subbands for such a comparison.

Fig. 3 shows how the analysis of energies of the coherent double sideband AM signal is performed for one pair of corresponding subbands SₙUSB, SₙLSB of both sidebands USB, LSB (n = 1 ... ns, i. e. number of subbands within one sideband). Fig. 3 shows the absolute values |H(jω)| of the audio spectrum of the lower sideband ASLSB and the audio spectrum of the upper sideband ASUSB over the frequency jω. In the shown example the audio spectrum of the lower sideband ASLSB shows no distortions and the audio spectrum of the upper sideband ASUSB shows one interferer IU. Further, the frequency range of subband SₙUSB of the upper sideband USB and the corresponding frequency range of subband SₙLSB of the lower sideband LSB are shown. Both subbands SₙUSB, SₙLSB have the same absolute value of their center frequency, i. e. the subband SₙLSB of the lower sideband LSB has the center frequency -jωₙ and the subband SₙUSB of the upper sideband USB has the center frequency +jωₙ. Furthermore, all pairs of such corresponding subbands with the same index n have the same width, i.e. cover the same frequency range.

To perform the subband analysis according to the present invention a bandpass filter with corresponding width of the passband and center frequency is used to determine the energy of a respective subband SₙUSB, SₙLSB. For each respective pair of subbands SₙUSB, SₙLSB the energies of the subband signals itself and of the difference signal of thereof are determined. Every pair of subbands with a level of the difference signal above a predetermined threshold is supposed to comprise one disturbed subband. To decide which subband is the disturbed one, the energies of the determined subbands of both single sideband signals are compared and the one with more energy is supposed to be the disturbed one.

A block diagram showing such a subband analysis is shown in Fig. 4. The received AM signal, i. e. the complex baseband signal is coherent demodulated to obtain the upper sideband signal USB and the lower sideband signal LSB. Both sideband signals USB, LSB are input to a subband analysator 1 which performs the bandpass filtering or another operation to determine a respective signal proportional to the energy of all respective subbands for every sideband USB, LSB. Every pair of the 2ns output signals SₙUSB, SₙLSB, n = 1 ... ns, of the subband analysator 1 which comprises the energies of corresponding subbands of both sidebands, i. e. which have the same index n, is input to a respective subtractor 2ₙ which outputs the difference signal thereof to a respective first energy determinator 3ₙ which calculates the energy of the difference signal and outputs it to a respective first comparator 6ₙ which compares it against a predetermined threshold. This predetermined threshold can be dependent on the number n of the subband, i. e. can take psychoacoustical considerations into account. Every respective comparator 6ₙ outputs a value indicating whether one subband SₙUSB, SₙLSB of the respective pair is disturbed or not. Alternatively, all output signals of all first energy determinators 3n might be input to one first comparator 6 which determines a predetermined number of disturbed subbands according to their relative level, i. e. a predetermined number of subbands having the highest levels are determined to be disturbed. This alternative can also take a threshold into consideration, e. g. to decrease the number of subbands determined to be disturbed.

To determine which sideband USB, LSB comprises the disturbed subband SₙUSB, SₙLSB every respective subband SₙUSB of the audio spectrum of the upper sideband USB is further input to a respective second energy determinator 4ₙ which outputs the energy of the input signal to a respective second comparator 7ₙ and every respective corresponding subband SₙLSB of the audio spectrum of the lower sideband LSB is input to a respective third energy determinator 5ₙ which outputs the energy of the input signal also the respective second comparator 7ₙ. Depending on which of both input signals has the higher value the respective second comparator 7ₙ indicates which of the respective pair of subbands SₙUSB, SₙLSB is the disturbed subband, i. e. whether the respective distortion lies within the upper sideband USB or within the lower sideband LSB.

Therefore, based on the information output by the respective first and second comparators 6ₙ and 7ₙ it is possible to determine which of both subbands SₙUSB, SₙLSB is disturbed. Furthermore, upon observating all output signals of first and second comparators 6ₙ, 7ₙ, (n = 1... number of subbands in one sideband), all disturbed subbands can be determined with their location in the upper or lower sideband.

As mentioned above, instead of dividing both single sideband signals into subbands and analyzing their difference signal in each subband it is alternatively also possible to analyze the quadrature component of the coherent complex double sideband signal. In disturbed subbands, there is also a maximum of energy in this signal component. This means that only one signal has to be fully divided into subband signals. The information, which sideband comprises the respective distortion has to be determined separately. Therefore, only for the disturbed subbands the single sideband signals have to be generated and divided into subbands and the disturbed one is supposed to be the one with more energy in its subband.

As also mentioned above, for the realization of the subband analysis according to the present invention different ways are proposed. The subband analysator might include a filterbank, a bandpass filter with variable center frequency which can be tuned over the whole frequency range, complex frequency shifters and lowpass filters, and/or a fast fourier transformer. The frequency range of the respective filters is determined depending on the wanted accuracy.

To find the maxima after each analysis block the energies of all subbands might be stored in a table. Preferably, all values are lowpass filtered to avoid fast switching effects in the further distortion filters.

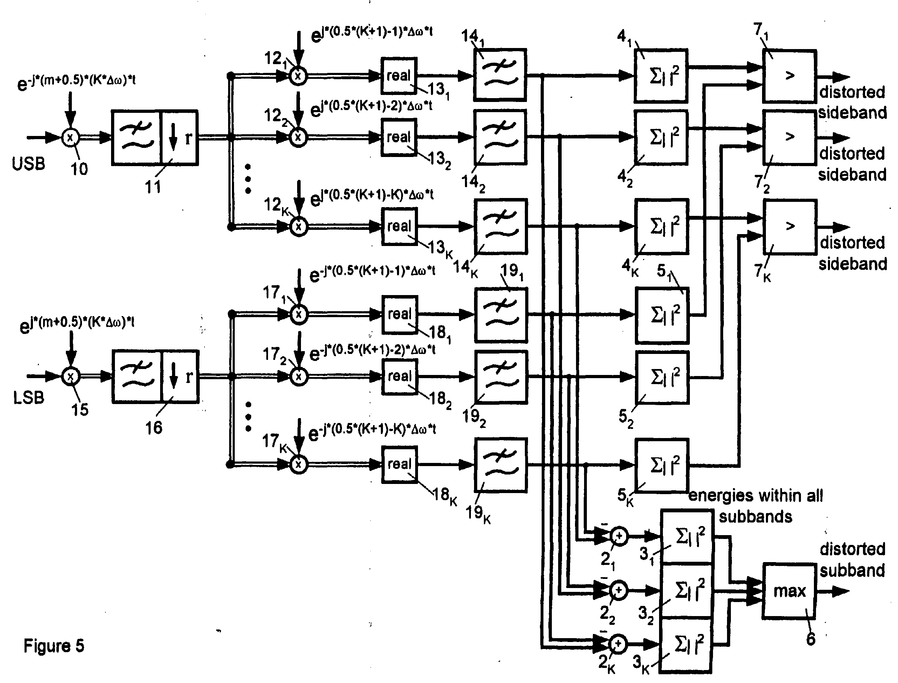

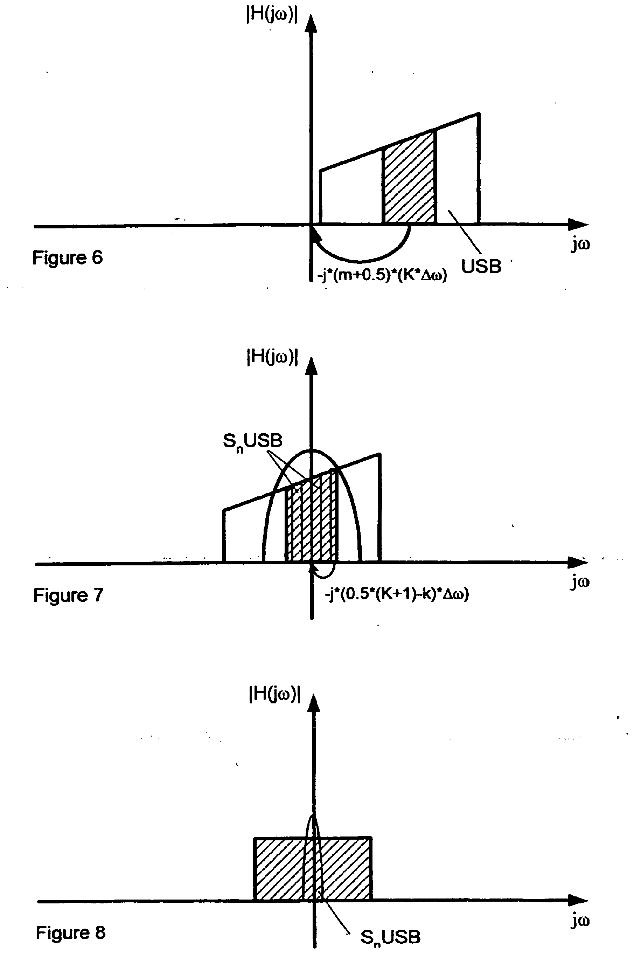

A more detailed block diagram showing a subband analysis according to the present invention which is performed using complex frequency shifts and lowpass filters is shown in Fig. 5. To elucidate Fig. 5, different signal processing stages and signals within these stages are shown in Figs. 6 to 8.

In this case each of both sideband signals USB, LSB is divided into M blocks of K subbands (K is an even integer) with bandwidth Δω which blocks are shifted to the low frequency range. For the upper sideband this division and shifting is performed by way of a first multiplier 10 which multiplies the upper sideband signal USB by e^{-j·(m+0.5)·(K·Δω)·t} and for the lower sideband signal LSB said division and shifting is performed by way of a second multiplier 15 multiplying the lower sideband signal LSB by e^{j·(m+0.5)·(K·Δω)·t} with m = 0,1...M-1. Fig. 6 shows this shifting and division for the upper sideband signal USB, i. e. Fig. 6 shows the upper sideband signal USB with three blocks of K subbands, wherein the middle block of K subbands will be shifted to the low frequency range.

Thereafter, to save calculation power and to be able to obtain better lowpass filters (S harder which leads to almost no overlap of subbands) the sample rate of the resulting complex signals is reduced. For the upper sideband signal USB this is performed by way of a first sample rate reducing unit 11 which reduces the sampling rate by a factor r and for the lower sideband signal LSB this is performed by a second sample rate reducing unit 16 which also reduces the sample rate by a factor r.

All single K subband signals are shifted to the low frequency range in parallel by respective K multipliers. For the upper sideband signal USB K third multipliers 12₁, 12₂, ..., 12_{K} are arranged in parallel which multiply the sampling rate reduced frequency shifted upper sideband signal USB by a corresponding factor to shift the respective subband to the low frequency range. Therefore, if the index of a third multiplier 12₁, 12₂, ..., 12_{K} is denoted as k = 1 ... K, a respective multiplication of the input signal with e^{j·(0,5(K+1)-k)·(Δω)·t} is performed. Similar, the sampling rate reduced frequency shifted lower sideband signal LSB is multiplied by respective fourth multipliers 17₁, 17₂, ... 17_{K} by a signal e^{j·(0.5(K+1)-k)·(Δω)·t}, k=1... K. This computation and the resulting signals are shown in Fig. 7, i. e. Fig. 7 shows the frequency shifts of the different subbands comprised in the block.

The resulting complex signals output from the respective third multipliers 12₁, 12₂, ..., 12_{K} are input to a respective first real part computation unit 13₁, 13₂, ... 13_{K} and the output signals of the respective fourth multipliers 17₁, 17₂, ... 17_{K} are input to respective second real part computation units 18₁, 18₂, ... 18_{K}.

Finally, before the subband energy analysis is performed as it is also shown in Fig. 4, all single K subbands of each sideband which are shifted to the low frequency range in parallel undergo a lowpass filtering in respective sets of lowpass filters 14₁, 14₂, ... 14_{K} for the upper sideband signal USB and second lowpass filters 19₁, 19₂, ... 19_{K} for the lower sideband signal LSB, which is shown in Fig. 8, i. e. Fig. 8 shows the final lowpass filtering of one subband shifted to the low frequency range (real part).

Fig. 5 shows three blocks of subtractors 2₁, 2₂ ... 2_{K} first energy determinators 3₁, 3₂ ... 3_{K}, second energy determinators 4₁, 4₂ ... 4_{K}, third energy determinators 5₁, 5₂ ... 5_{K} and second comparators 7₁, 7₂ ... 7_{K} and one first comparator 6 which determines the maximum within all ns subbands to determine the most distorted subband in this range.

## Claims

1. Method to detect distortions in an AM signal, **characterized by** the following steps:
- coherently demodulating the received AM signal to obtain an upper sideband signal (USB) and a lower sideband signal (LSB),
- determining and analyzing the energies of respective corresponding subbands (SₙUSB, SₙLSB) of the upper and the lower sideband signal (USB, LSB) and of a respective difference signal thereof to determine whether the respective subband (SₙUSB, SₙLSB) of the respective sideband signal (USB, LSB) is disturbed or not; and
- determining, in case that the respective difference signal has a level above a predetermined threshold, the corresponding subband signal (SₙUSB, SₙLSB) with higher energy as disturbed subband signal.

2. Method according to claim 1, **characterized in that**
- when the energies of respective corresponding subbands (SₙUSB, SₙLSB) of the upper or the lower sideband signal (USB, LSB) are analyzed,
- all frequencies having a level of the quadrature component, being equal to the difference of both sideband signals, of the coherent complex double sideband signal lying above a predetermined threshold are determined to be disturbed frequencies and the respective corresponding subband (SₙUSB, SₙLSB) of both sideband signals (USB, LSB) at one of those disturbed frequencies having the higher energy is determined to be the disturbed subband.

3. Method according to anyone of the preceding claims, **characterized in that** the subband analysis is performed using
- a filter bank;
- a bandpass filter with variable center frequency which can be tuned over the whole frequency range;
- complex frequency shifts and lowpass filters; and/or
- a fast fourier transformation.

4. Method according to anyone of the preceding claims, **characterized in that** at least groups of subbands are processed in parallel.

5. Method according to anyone of the preceding claims, **characterized in that** all energy values of subbands (SₙUSB, SₙLSB) obtained during the respective subband analysis are lowpass filtered.

6. Method according to anyone of the preceding claims, **characterized in that** a psychoacoustical weighting factor is considered when determining whether a subband (SₙUSB, SₙLSB) is disturbed or not.

7. Method according to anyone of the preceding claims, **characterized in that** said distortions are narrow band distortions.

8. Method according to anyone of the preceding claims, **characterized in that** an average level is generated based on the energy of a respective subband.

9. Device to detect distortions in an AM signal, **characterized by**:
- means (1) for coherently demodulating the received AM signal to obtain an upper sideband signal (USB) and a lower sideband signal (LSB);
- means (3 to 5) for determining and analyzing the energies of respectives corresponding subbands (SₙUSB. SₙLSB) of the upper and the lower sideband signal (USB, LSB) and of a respective difference signal thereof to determine whether the respective subband (SₙUSB, SₙLSB) of the respective sideband signal (USB, LSB) is disturbed or not; and
- means (6, 7) for determining, in case that the respective difference signal has a level above a predetermined threshold, the corresponding subband signal (SₙUSB, SₙLSB) with higher energy as disturbed subband signal.

10. Device to detect distortions in an AM signal, **characterized by**:
- means (1) for coherently demodulating the received AM signal to obtain an upper sideband signal (USB) and a lower side band signal (LSB);
- means (3 to 5) for analyzing the energies of subbands (SₙUSB, SₙLSB) of the upper or the lower sideband signal (USB, LSB) to determine whether the respective subband (SₙUSB, SₙLSB) of the respective sideband signal (USB, LSB) is disturbed or not;
- means (6, 7) for determining all frequencies having a level of the quadrature component, being equal to the difference of both sideband signals, of the coherent complex double sideband signal lying above a predetermined threshold to be disturbed frequencies; and
- means for determining the respective corresponding subband (SₙUSB. SₙLSB) of both sideband signals (USB, LSB) at one of those disturbed frequencies having the higher energy to be the disturbed subband.

11. Device according to claim 9 or 10, **characterized in that** at least groups of subbands are processed in parallel.

12. Device according to claim 11, **characterized by** first multipliers (12ₖ; k = 1...K) to shift a group of K subbands of an upper sideband signal of the AM signal to the low frequency range by a multiplication with
e^{j(0,5(K+1)-k)·Δω·t}, k = 1...K
and second multipliers (17ₖ; k = 1...K) to shift a group of K subbands of a lower sideband signal of the AM signal to the low frequency range by a multiplication with
e^{-j(0,5(K+1)-k)·Δω·t} , k = 1...K

## Patentansprüche

1. Verfahren zur Detektion von Verzerrungen in einem AM-Signal, **gekennzeichnet durch** die folgenden Schritte:
- kohärentes Demodulieren des empfangenen AM-Signals, um ein oberes Seitenbandsignal (USB) und ein unteres Seitenbandsignal (LSB) zu erhalten;
- Ermitteln und Analysieren der Energien jeweils entsprechender Unterbänder (SₙUSB, SₙLSB) des oberen und des unteren Seitenbandsignals (USB, LSB) und eines jeweiligen Differenzsignals derselben, um zu ermitteln, ob das jeweilige Unterband (SₙUSB, SₙLSB) des jeweiligen Seitenbandsignals (USB, LSB) gestört ist oder nicht; und
- falls das jeweilige Differenzsignal einen Pegel oberhalb eines vorbestimmten Schwellenwerts hat, Ermitteln des entsprechenden Unterbandsignals (SₙUSB, SₙLSB) mit höherer Energie als gestörtes Unterbandsignal.

2. Verfahren nach Anspruch 1, **dadurch gekennzeichnet, dass**
- dann, wenn die Energien jeweils entsprechender Unterbänder (SₙUSB, SₙLSB) des oberen und des unteren Seitenbandsignals (USB, LSB) analysiert werden,
- alle Frequenzen mit einem Pegel der Quadraturkomponente - welche gleich der Differenz beider Seitenbandsignale ist - des kohärenten komplexen Doppelseitenbandsignals, der oberhalb eines vorbestimmten Schwellenwerts liegt, als gestörte Frequenzen ermittelt werden, und das jeweils entsprechende Unterband (SₙUSB, SₙLSB) beider Seitenbandsignale (USB, LSB) bei einer dieser gestörten Frequenzen mit der höheren Energie als das gestörte Unterband ermittelt wird.

3. Verfahren nach einem der vorangehenden Ansprüche, **dadurch gekennzeichnet, dass** die Unterbandanalyse durchgeführt wird unter Verwendung
- einer Filterbank;
- eines Bandpassfilters mit variabler Mittenfrequenz, welche über den gesamten Frequenzbereich abgestimmt werden kann;
- komplexer Frequenzverschiebungen und von Tiefpassfiltern; und/oder
- einer schnellen Fourier-Transformation.

4. Verfahren nach einem der vorangehenden Ansprüche, **dadurch gekennzeichnet, dass** zumindest Gruppen von Unterbändern parallel verarbeitet werden.

5. Verfahren nach einem der vorangehenden Ansprüche, **dadurch gekennzeichnet, dass** alle Energiewerte von Unterbändern (SₙUSB, SₙLSB), die während der jeweiligen Unterbandanalyse erhalten wurden, tiefpassgefiltert werden.

6. Verfahren nach einem der vorangehenden Ansprüche, **dadurch gekennzeichnet, dass** bei dem Ermitteln, ob ein Unterband (SₙUSB, SₙLSB) gestört ist oder nicht, ein pyschoakustischer Gewichtungsfaktor berücksichtigt wird.

7. Verfahren nach einem der vorangehenden Ansprüche, **dadurch gekennzeichnet, dass** die Störungen Schmalbandstörungen sind.

8. Verfahren nach einem der vorangehenden Ansprüche, **dadurch gekennzeichnet, dass** ein mittlerer Pegel auf der Grundlage der Energie eines jeweiligen Unterbands erzeugt wird.

9. Vorrichtung zur Detektion von Störungen in einem AM-Signal, **gekennzeichnet durch**:
- eine Einrichtung (1) zum kohärenten Demodulieren des empfangenen AM-Signals, um ein oberes Seitenbandsignal (USB) und ein unteres Seitenbandsignal (LSB) zu erhalten;
- eine Einrichtung (3 bis 5) zum Ermitteln und Analysieren der Energien jeweils entsprechender Unterbänder (SₙUSB, SₙLSB) des oberen und des unteren Seitenbandsignals (USB, LSB) und eines jeweiligen Differenzsignals derselben, um zu ermitteln, ob das jeweilige Unterband (SₙUSB, SₙLSB) des jeweiligen Seitenbandsignals (USB, LSB) gestört ist oder nicht; und
- eine Einrichtung (6, 7) zum, falls das jeweilige Differenzsignal einen Pegel oberhalb eines vorbestimmten Schwellenwerts hat, Ermitteln des entsprechenden Unterbandsignals (SₙUSB, SₙLSB) mit höherer Energie als gestörtes Unterbandsignal.

10. Vorrichtung zur Detektion von Störungen in einem AM-Signal, **gekennzeichnet durch**:
- eine Einrichtung (1) zum kohärenten Demodulieren des empfangenen AM-Signals, um ein oberes Seitenbandsignal (USB) und ein unteres Seitenbandsignal (LSB) zu erhalten;
- eine Einrichtung (3 bis 5) zum Analysieren der Energien von Unterbändern (SₙUSB, SₙLSB) des oberen und des unteren Seitenbandsignals (USB, LSB), um zu ermitteln, ob das jeweilige Unterband (SₙUSB, SₙLSB) des jeweiligen Seitenbandsignals (USB, LSB) gestört ist oder nicht;
- eine Einrichtung (6, 7) zum Ermitteln aller Frequenzen mit einem Pegel der Quadraturkomponente - welche gleich der Differenz beider Seitenbandsignale ist - des kohärenten komplexen Doppelseitenbandsignals, der oberhalb eines vorbestimmten Schwellenwerts liegt, als gestörte Frequenzen; und
- eine Einrichtung zum Ermitteln des jeweils entsprechenden Unterbands (SₙUSB, SₙLSB) beider Seitenbandsignale (USB, LSB) bei einer dieser gestörten Frequenzen mit der höheren Energie als das gestörte Unterband.

11. Vorrichtung nach Anspruch 9 oder 10, **dadurch gekennzeichnet, dass** zumindest Gruppen von Unterbändern parallel verarbeitet werden.

12. Vorrichtung nach Anspruch 11, **gekennzeichnet durch** erste Multiplizierer (12ₖ; k = 1 ... K) zum Verschieben einer Gruppe von K Unterbändern eines oberen Seitenbandsignals des AM-Signals in den Niedrigfrequenzbereich **durch** eine Multiplikation mit
e^{j(0,5(K+1)-k)·Δω·t}, k = 1 ... K
und zweite Multiplizierer (17ₖ; k = 1 ... K) zum Verschieben einer Gruppe von K Unterbändern eines unteren Seitenbandsignals des AM-Signals in den Niedrigfrequenzbereich durch eine Multiplikation mit
e^{-j(0,5(K+1)-k)·Δω·t}, k = 1... K

## Revendications

1. Procédé de détection de distorsions dans un signal AM, **caractérisé par** les étapes suivantes :
- démodulation cohérente du signal AM reçu pour obtenir un signal de bande latérale supérieure (USB) et un signal de bande latérale inférieure (LSB) :
- détermination et analyse des énergies des sous-bandes respectives correspondantes (Sₙ, USB, Sₙ, LSB) du signal de bande latérale supérieure et inférieure (USB, LSB) et d'un signal de différence respectif de celui-ci pour déterminer si la sous-bande respective (Sₙ, USB, Sₙ, LSB) du signal de bande latérale respective (USB, LSB) est perturbée ou non ; et
- dans le cas où le signal de différence respectif a un niveau supérieur à un seuil prédéterminé, détermination du signal de sous-bande respectif (Sₙ, USB, Sₙ, LSB) ayant une énergie supérieure au signal de sous-bande perturbée.

2. Procédé selon la revendication 1, **caractérisé en ce que**
- lorsque les énergies des sous-bandes respectives correspondantes (Sₙ, USB, Sₙ, LSB) du signal de bande latérale supérieure ou inférieure (USB, LSB) sont analysées,
toutes les fréquences ayant un niveau de la composante en quadrature, étant égales à la différence des deux signaux de bande latérale, du signal de bande double complexe cohérent supérieur à un seuil prédéterminé sont déterminées comme étant des fréquences perturbées et la sous-bande respective correspondante (Sₙ, USB, Sₙ, LSB) des deux signaux de bande (USB, LSB) à une de ces fréquences perturbées ayant l'énergie supérieure est déterminée comme étant la sous-bande perturbée.

3. Procédé selon l'une quelconque des revendications précédentes, **caractérisé en ce que** l'analyse des sous-bandes est réalisée à l'aide
- d'un banc de filtres ;
- d'un filtre passe-bande à fréquence centrale variable qui peut être syntonisé sur toute la gamme de fréquences ;
- de déplacements de fréquence complexes et de filtres passe-bas ; et/ou
- d'une transformation de Fourier rapide.

4. Procédé selon l'une quelconque des revendications précédentes, **caractérisé en ce qu'**au moins des groupes de sous-bandes sont traités en parallèle.

5. Procédé selon l'une quelconque des revendications précédentes, **caractérisé en ce que** toutes les valeurs d'énergie des sous-bandes (Sₙ, USB, Sₙ, LSB) obtenues pendant l'analyse de sous-bande respective sont filtrées par filtre passe-bas.

6. Procédé selon l'une quelconque des revendications précédentes, **caractérisé en ce qu'**un facteur de pondération psychoacoustique est pris en compte pour déterminer si une sous-bande (Sₙ, USB, Sₙ, LSB) est perturbée ou non.

7. Procédé selon l'une quelconque des revendications précédentes, **caractérisé en ce que** lesdites distorsions sont des distorsions à largeur de bande étroite.

8. Procédé selon l'une quelconque des revendications précédentes, **caractérisé en ce qu'**un niveau moyen est généré sur la base de l'énergie d'une sous-bande respective.

9. Dispositif pour la détection de distorsions dans un signal AM, **caractérisé par** :
- des moyens (1) pour démoduler de manière cohérente le signal AM reçu pour obtenir un signal de bande latérale supérieure (USB) et un signal de bande latérale inférieure (LSB) ;
- des moyens (3 à 5) pour déterminer et analyser les énergies des sous-bandes respectives correspondantes (Sₙ, USB, Sₙ, LSB) du signal de bande latérale supérieure et inférieure (USB, LSB) et d'un signal de différence respectif de celui-ci pour déterminer si la sous-bande respective (Sₙ, USB, Sₙ, LSB) du signal de bande latérale respective (USB, LSB) est perturbée ou non ; et
- des moyens (6, 7) pour déterminer, dans le cas où le signal de différence respectif a un niveau supérieur à un seuil prédéterminé, le signal de sous-bande respectif (Sₙ, USB, Sₙ, LSB) ayant une énergie supérieure au signal de sous-bande perturbée.

10. Dispositif pour la détection de distorsions dans un signal AM, **caractérisé par** :
- des moyens (1) pour démoduler de manière cohérente le signal AM reçu pour obtenir un signal de bande latérale supérieure (USB) et un signal de bande latérale inférieure (LSB) ;
- des moyens (3 à 5) pour analyser les énergies des sous-bandes (Sₙ, USB, Sₙ, LSB) du signal de bande latérale supérieure et inférieure (USB, LSB) pour déterminer si la sous-bande respective (Sₙ, USB, Sₙ, LSB) du signal de bande latérale respective (USB, LSB) est perturbée ou non ;
- des moyens (6, 7) pour déterminer toutes les fréquences ayant un niveau de la composante en quadrature, étant égales à la différence des deux signaux de bande latérale, du signal de bande double complexe cohérent supérieur à un seuil prédéterminé comme des fréquences perturbées ; et
- des moyens pour déterminer la sous-bande respective correspondante (Sₙ, USB, Sₙ, LSB) des deux signaux de bande (USB, LSB) à une de ces fréquences perturbées ayant l'énergie supérieure comme la sous-bande perturbée.

11. Dispositif selon la revendication 9 ou 10, **caractérisé en ce qu'**au moins des groupes de sous-bandes sont traités en parallèle.

12. Dispositif selon la revendication 11, **caractérisé par** des premiers multiplicateurs (12ₖ ; k = 1 ...K) pour déplacer un groupe de K sous-bandes d'un signal de bande latérale supérieure du signal AM vers la gamme de basses fréquences par une multiplication avec
e^{j(0,5(K+1)-k)·Δω·t} ,k = 1...K
et
des deuxièmes multiplicateurs (17ₖ ; k = 1 ...K) pour déplacer un groupe de K sous-bandes d'un signal de bande latérale inférieure du signal AM vers la gamme de basses fréquences par une multiplication avec
e^{-j(0,5(K+1)-k)·Δω·t}, k = 1...K
